(19) Europäisches Patentamt
European Patent Office
Office européen des brevets

(11) EP 2 633 566 B1

(12) # FASCICULE DE BREVET EUROPEEN

(45) Date de publication et mention de la délivrance du brevet:
**29.04.2015 Bulletin 2015/18**

(21) Numéro de dépôt: **11824268.4**

(22) Date de dépôt: **28.10.2011**

(51) Int Cl.:
***H01L 51/00*** *(2006.01)* ***H01L 51/05*** *(2006.01)*

(86) Numéro de dépôt international:
**PCT/FR2011/052529**

(87) Numéro de publication internationale:
**WO 2012/093210 (12.07.2012 Gazette 2012/28)**

(54) **CONDUCTION ÉLECTRIQUE PAR DES ASSEMBLAGES SUPRAMOLÉCULAIRES DE TRIARYLAMINES**

ELEKTRISCHE LEITUNG MITTELS SUPRAMOLEKULARER ANORDNUNGEN AUS TRIARYLAMINEN

ELECTRICAL CONDUCTION BY MEANS OF SUPRAMOLECULAR ASSEMBLIES OF TRIARYLAMINES

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **29.10.2010 FR 1058954**
**01.12.2010 US 418645 P**

(43) Date de publication de la demande:
**04.09.2013 Bulletin 2013/36**

(73) Titulaires:
- **Centre National de la Recherche Scientifique (CNRS)**
  **75016 Paris (FR)**
- **Université de Strasbourg**
  **67000 Strasbourg (FR)**

(72) Inventeurs:
- **GIUSEPPONE, Nicolas**
  **F-67000 Strasbourg (FR)**
- **DAYEN, Jean-François**
  **F-67100 Strasbourg (FR)**
- **FARAMARZI, Vina**
  **F-67000 Strasbourg (FR)**
- **MOULIN, Emilie**
  **F-67980 Hangenbieten (FR)**
- **NIESS, Frederic**
  **F-67201 Eckbolsheim (FR)**
- **DOUDIN, Bernard**
  **F-67000 Strasbourg (FR)**

(74) Mandataire: **Domenego, Bertrand**
**Cabinet Lavoix**
**2, place d'Estienne d'Orves**
**75441 Paris Cedex 09 (FR)**

(56) Documents cités:
- **DAYEN, J.-F., FARAMARZI, V., PAULY, M., KEMP, N.T., BARBERO, M., PICHON, B.P., MAJJAD, H., BEGIN-COLIN, S., DOUDIN, B.: "Nanotrench for nano and microparticle electrical interconnects", NANOTECHNOLOGY, vol. 21, 27 juillet 2010 (2010-07-27), pages 335303-1-335303-7, XP002639891, cité dans la demande**
- **MOULIN, E., NIESS, F., MAALOUM, M., BUHLER, E., NYRKOVA, I., GIUSEPPONE, N.: "The Hierarchical Self-Assembly of Charge Nanocarriers: A Highly Cooperative Process Promoted by Visible Light", ANGEWANDTE CHEMIE, vol. 49, 19 juillet 2010 (2010-07-19), pages 6974-6978, XP002639892,**
- **SANO, H., MAEDA, H.,MATSUOKA, S., LEE, K.-H., MURASE, K. AND SUGIMURA, H.: "Self-Assembled Monolayers Directly Attached to Silicon Substrates Formed from 1-Hexadecene by Thermal, Ultraviolet, and Visible Light Activation Methods", JAPANESE JOURNAL OF APPLIED PHYSICS, vol. 47, no. 7, 11 juillet 2008 (2008-07-11), pages 5659-5664, XP002639893,**
- **HASEGAWA, M. AND IYODA, M.: "Conducting supramolecular nanofibers and nanorods", CHEM. SOC. REV., vol. 39, 16 mars 2010 (2010-03-16), pages 2420-2427, XP002639894,**

Il est rappelé que: Dans un délai de neuf mois à compter de la publication de la mention de la délivrance du brevet européen au Bulletin européen des brevets, toute personne peut faire opposition à ce brevet auprès de l'Office européen des brevets, conformément au règlement d'exécution. L'opposition n'est réputée formée qu'après le paiement de la taxe d'opposition. (Art. 99(1) Convention sur le brevet européen).

EP 2 633 566 B1

• WELZEL, P., GÜNTHER, L. AND ECKHARDT, G.: "Die termische Umlagerung von Tetraarylhydrazinen. Über die C-N-Verknüpfung bei der Bildung von Semidin-Derivaten", CHEMISCHE BERICHTE, vol. 107, 18 juillet 1974 (1974-07-18), pages 3624-3639, XP002639895,

## Description

La présente invention a trait au domaine de la connexion électrique d'éléments solides conducteurs séparés entre eux par de faibles distances, typiquement de l'ordre de quelques dizaines à quelques centaines de nanomètres, par exemple des éléments solides conducteurs du type de ceux mis en oeuvre dans les dispositifs électroniques et optoélectroniques, comme les diodes électroluminescentes (LEDs et OLEDS), les transistors à effet de champ (FETs et OFETs) et les dispositifs photovoltaïques tels que les cellules solaires. L'invention concerne par exemple, selon un aspect particulier, la fabrication ou la réparation de circuits électroniques (circuits imprimés notamment) où une connexion électrique doit être établie entre des composants par exemple après avoir été rompue.

A ce jour, pour réaliser une connexion électrique du type précité, entre des éléments solides conducteurs séparés par de faibles distances, il a été proposé diverses méthodes qui s'avèrent généralement insatisfaisantes ou limitées.

Ainsi, il a par exemple été envisagé de déposer des poudres métalliques entre les conducteurs à connecter. L'emploi d'une poudre métallique de ce type conduit généralement à une connexion électrique, mais qui s'avère en général relativement difficile à localiser de façon précise, ce qui peut conduire à des connexions non souhaitées entre d'autres conducteurs électriques que ceux qu'on souhaite interconnecter. De plus, l'efficacité de la connexion électrique obtenue avec une poudre métallique se révèle souvent assez médiocre. En effet, schématiquement, les poudres conduisent à des contacts ponctuels avec les conducteurs à connecter, ce qui n'induit pas une connexion électrique optimale. De façon plus générale, l'emploi de métaux pour la réalisation de dispositifs électroniques passe généralement par des étapes de mise en forme compliquées et/ou onéreuses et conduisent en général à des dispositifs rigides.

Alternativement, pour la fabrication de dispositifs électroniques, il a été proposé d'employer des polymères conducteurs, qui sont typiquement déposés entre des conducteurs à connecter au sein d'un solvant qui est ensuite évaporé. Certains des polymères proposés dans ce cadre s'avèrent relativement intéressants pour la connexion d'éléments conducteurs métalliques spécifiques, notamment dans la mesure où ils permettent d'obtenir des dispositifs plus souples que ceux obtenus avec des métaux, et avec des coûts généralement plus faibles. Cependant, là encore, lorsqu'on souhaite connecter deux solides conducteurs avec un polymère, il est souvent difficile de cantonner le dépôt de ce polymère à une zone bien délimitée. De plus, lorsqu'un polymère conducteur conduit à des résultats intéressants avec un conducteur métallique donné, ces résultats ne sont en général pas transposables à d'autres conducteurs métalliques. En effet, l'efficacité de la connexion électrique réalisée avec un polymère organique conducteur dépend le plus souvent de l'adéquation des bandes de valence et d'absorption du polymère et du conducteur métallique auquel il est relié.

En outre, les polymères organiques conducteurs ont l'inconvénient de présenter un comportement de conducteurs non ohmiques. Un autre aspect négatif lié à l'emploi des polymères organiques conducteurs est qu'ils contiennent souvent des ions métalliques à titre de dopants, qui peuvent avoir un impact non négligeable en termes de toxicité et de répercussions néfastes sur l'environnement, ce qui constitue un frein à leur utilisation à l'échelle industrielle.

Une autre possibilité pour relier deux électrodes à l'aide d'un conducteur organique est de déposer précisément des nanotubes de carbones métalliques. Ceci présente en effet des résistances d'interfaces très faibles et un comportement ohmique avec une conduction de type métallique. Cependant, la difficulté d'isoler et de positionner ces nanotubes sur des contacts métallique rend la encore cette méthode difficile à mettre en oeuvre et d'un coût élevé.

DAYEN J.-F. et al. : « Nanotrench for nano and microparticle electrical interconnects » NANOTECHNOLOGY, vol. 21, 2010-07-27, pages 335303-1-335303-7, divulgue un dispositif conducteur comprenant une première électrode Ti/Au et une deuxième électrode Ti/Au, interconnectées électriquement (on applique une différence de potentiel, généralement négative) par un matériau inorganique (une suspension de nanoparticules d'oxyde de fer dans le chloroforme).

Un but de la présente invention est de fournir une méthode qui permette, entre autres, de connecter électriquement deux éléments solides conducteurs, de façon précise, simple, répétable et efficace, et ce de préférence en évitant les inconvénients des méthodes précitées, notamment en assurant entre les deux conducteurs une conduction de type ohmique efficace.

A cet effet, la présente invention propose un nouveau dispositif conducteur, un nouveau matériau conducteur et un nouveau procédé, qui donne accès au dépôt de structures fibrillaires organiques conductrices à la surface (S) d'un matériau conducteur solide, ce qui permet, entre autres, la connexion de cette surface (S) ainsi modifiée avec une surface (S') d'un autre solide conducteur placé en regard de la surface porteuse des structures fibrillaires, lorsque cette autre surface (S') est à une distance suffisamment faible pour que les structure fibrillaires puissent former une connexion entre les deux surfaces (S) et (S') en regard l'une de l'autre.

Plus précisément, selon la revendication indépendante 5, la présente invention a pour objet un procédé de modification d'une surface (S) d'un matériau conducteur solide, qui comprend une étape (E), dans laquelle on applique une différence de potentiel, en général négative, entre ladite surface (S) et une surface (S') d'un autre matériau solide conducteur disposé en regard de ladite surface (S), simultanément à la mise en contact de ladite surface (S) avec un milieu liquide comprenant, en solution, des triarylamines répondant à la formule (I) ci-après :

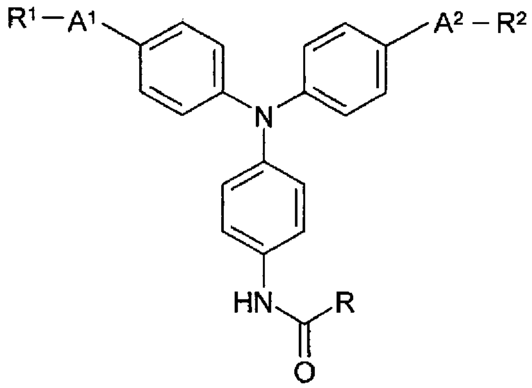

(I)

où :

- chacun des groupes $-A^1-$ et $-A^2-$, identiques ou différents (et de préférence identiques), désigne une liaison covalente simple ou bien un groupe -O- ou -S-, -NH-, NH(C=O), ou $-NR^3-$, et de préférence un groupe-O-;
- chacun des groupes $R^1$, $R^2$ et $R^3$, identiques ou différents ($R^1$ et $R^2$ étant de préférence identiques), représente :
  - un groupe aromatique, de préférence un groupe benzyle ; ou
  - une chaîne hydrocarbonée (de préférence linéaire) comprenant de 4 à 30, par exemple de 5 à 20 atomes de carbone, de préférence une chaîne grasse, notamment un groupe alkyle, avantageusement linéaire ; ou
  - une chaîne polyéthylène glycol ;

  et
- R est un groupe de terminaison, qui est de préférence une chaîne hydrocarbonée linéaire ou ramifiée, comprenant avantageusement de 1 à 10 atomes de carbone, éventuellement halogénée et éventuellement interrompue par un ou plusieurs hétéroatomes choisis parmi N, O ou S, R étant plus préférentiellement un groupe alkyle, éventuellement halogéné, comprenant de préférence de 1 à 8 atomes de carbone,

tout en soumettant les triarylamines (I) à une radiation électromagnétique ou encore à une oxydation chimique ou électrochimique, propre à les convertir au moins en partie en des radicaux triarylammonium, cette irradiation pouvant typiquement être réalisée à l'aide de lumière solaire dans un solvant chloré (dichlorométhane, chloroforme, tetrachloroéthane, dichlorobenzène, etc.).

Les travaux qui ont été conduits par les inventeurs dans le cadre de la présente invention ont maintenant permis de mettre en évidence que la mise en oeuvre de l'étape (E) telle que définie ci-dessus permet d'obtenir, de façon extrêmement simple et rapide, un dépôt d'espèces organiques conductrices, de forme fibrillaire (à savoir présentant globalement la morphologie d'une petite fibre), et immobilisées sur la surface (S) du matériau conducteur solide. Ces espèces organiques fibrillaires conductrices, objets de l'invention, sont constituées d'une association supramoléculaire des triarylamines de formule (I), du type des associations qui ont été décrites en solution par les inventeurs dans Angew. Chem. Int. Ed., vol. 49, pp. 6974-6978 (2010), ces espèces supramoléculaires fibrillaires étant selon la présente invention spécifiquement greffées sur la surface (S) du matériau conducteur solide à l'issue de l'étape (E).

La présente invention concerne selon les revendications indépendantes 14 et 1 un matériau et un dispositif conducteur, respectivement, comprenant deux matériaux métalliques conducteurs dont les surfaces, respectivement (S) et (S'), sont interconnectées électriquement par un matériau organique comprenant des espèces supramoléculaires organiques fibrillaires conductrices comprenant une association des triarylamines de formule (I).

Par « conducteurs » il est fait référence à la conduction électrique.

On entend par « interconnecté électriquement », le fait de pouvoir présenter de préférence une conductivité supérieure à $10^3$ $S.m^{-1}$, et généralement de $10^4$ $S.m^{-1}$ à $10^5$ $S.m^{-1}$. Les dispositifs de l'invention présentent des valeurs de courant (I) atteignant la plage des mA. La conductance est généralement de l'ordre de quelques dizaines de mS. Selon un mode préféré, les dispositifs de l'invention présentent avantageusement une nature résistive ohmique.

Un autre aspect qui ne fait pas partie des revendications, concerne un procédé de préparation des espèces supramoléculaires précitées. Ce procédé comporte une étape dans laquelle on soumet un milieu liquide contenant des triarylamines de formules (I) à une radiation électromagnétique (typiquement au rayonnement solaire), ou encore à une oxydation chimique ou électrochimique, propre à les convertir au moins en partie en des radicaux triarylammonium, tout en en les soumettant à un champ électrique, typiquement de 200 à 600 mV, par exemple entre 250 et 500 mV.

Ces espèces supramoléculaires ont typiquement la forme de petites fibres ayant une longueur de l'ordre de

10 nm à 1000 nm, notamment entre 50 et 1000 nm, et un diamètre de 5 à 50 nm, par exemple de 10 à 50 nm. Compte tenu de l'application d'une différence de potentiel entre les surface (S) et (S') lors de l'étape (E), ces fibres se forment de façon localisée entre les deux surfaces et parallèlement aux lignes de champ électrique. Par ailleurs, elles se greffent systématiquement sur la surface (S), ce qui permet d'éliminer la formation d'espèces supramoléculaires fibrillaires libres (c'est-à-dire non pontantes entre les électrodes) après rinçage. Le procédé permet ainsi, contrairement aux techniques actuelles, de réaliser un dépôt extrêmement localisé des composés organiques conducteurs, uniquement dans la zone située entre les deux surfaces. De façon inattendue au vu des techniques existant à ce jour pour réaliser ce type de dépôt, cette localisation précise est en outre réalisée de façon directe sans avoir à mettre en oeuvre de moyens onéreux ou compliqués. Ainsi, de façon générale, l'étape (E) permet, de façon simple, efficace et peu onéreuse (simplement en introduisant les composés de formule (I) en solution entre les deux surfaces (S) et (S'), en appliquant une simple différence de potentiel entre ces deux surfaces et en soumettant l'ensemble à une irradiation, typiquement par de la lumière solaire) de greffer des structures fibrillaires organiques à caractère conducteur électrique à la surface d'un solide conducteur.

Selon un mode de réalisation particulièrement intéressant, l'étape (E) est conduite avec une distance entre les surface (S) et (S') suffisamment faible pour que les associations supramoléculaires fibrillaires formées sur la surface (S) entrent en contact avec la surface (S'). Dans ce cas, l'étape (E) conduit à une connexion électrique des surface conductrices (S) et (S'). Typiquement, dans ce cas, les surfaces en regard (S) et (S') sont distantes de 1 micron ou moins, ou, tout au moins, il existe au moins une zone de la surface (S) distante d'une zone de la surface (S') de 1 micron ou moins (par exemple de 10 à 1000 nm). Préférentiellement, lorsqu'on cherche à connecter électriquement les surfaces (S) et (S'), celles-ci sont parallèles ou sensiblement parallèles, avec un écart entre les deux surfaces allant de préférence de 10 à 1000 nm, par exemple de 50 à 500 nm.

Selon un mode de réalisation particulier ledit matériau ou dispositif conducteur présente une interface métallique/organique et les surfaces (S) et (S') sont séparées d'une distance de 10 à 500 nm, et de préférence de 50 à 200 nm, dans lequel ledit matériau organique comprenant des espèces supramoléculaires organiques fibrillaires comble la distance séparant les surfaces (S) et (S') des deux matériaux métalliques. Ladite distance est typiquement de $80 \pm 20$ nm. On parle de « nano-sillon ».

Selon une variante, le matériau et le dispositif de l'invention présentent une longueur des surfaces (S) et (S') en regard l'une de l'autre comprise entre 10 $\mu$m et 1000$\mu$m, et de préférence de 50 à 500$\mu$m. Ladite longueur est typiquement d'environ 100$\mu$m.

Selon une variante préférée, les espèces supramoléculaires organiques fibrillaires sont orientées en faisceau parallèle de « nanofils » s'étendant radialement par rapport aux surfaces conductrices (S) et (S'), c'est-à-dire de manière à ce que la plus grande longueur des espèces fibrillaires joigne lesdites surfaces(S) et (S').

On préfère des espèces supramoléculaires organiques fibrillaires dont la longueur correspond à la distance séparant les surfaces (S) et (S') des deux matériaux métalliques.

De préférence les matériaux métalliques sont des matériaux métalliques d'électrodes conductrices. On préfère comme matériau des métaux choisis parmi les métaux de transition, et de préférence parmi l'or (Au), le nickel (Ni), le titane (Ti), l'argent (Ag), le fer (Fe), le platine (Pt), le cuivre (Cu), le cobalt (Co), le zinc (Zn), le chrome (Cr), le manganèse (Mn), ou des alliages comprenant un ou plusieurs de ces métaux. Les électrodes peuvent comprendre une association ou être constituées d'or et de nickel, ou de nickel et de fer, ou de cuivre et d'or, ou d'argent et d'or, avec de préférence l'or en surface de l'électrode.

'Selon la revendication indépendante 15, l'utilisation d'espèces supramoléculaires organiques fibrillaires comprend des triarylamines répondant à la formule (I) pour relier entre elles les surfaces (S) et (S') de deux électrodes conductrices. Les électrodes peuvent être des électrodes métalliques précitées.

De préférence, au moins une électrode comprend un métal de transition, et de préférence l'ensemble des électrodes utilisées (par ex. l'électrode positive et l'électrode négative).

Selon une variante, le métal conducteur d'au moins une électrode est recouvert d'un dépôt d'or (Au). De préférence l'ensemble des électrodes utilisées comprennent un dépôt d'or (par ex. l'électrode positive et l'électrode négative).

Dans le cas particulier où l'étape (E) est employée pour réaliser la connection électrique des surfaces (S) et (S') selon le mode de réalisation spécifique décrit ci-dessus, elle conduit, comme c'est systématiquement le cas dans l'étape (E), à la formation des espèces supramoléculaires fibrillaires de façon exclusivement localisée au sein de l'espace compris entre les deux surfaces, sans risque de dépôt de composés organiques conducteurs dans d'autres zones. Le procédé s'avère de ce fait particulièrement sélectif et ciblé, contrairement à la plupart des techniques mettant en oeuvre des composés organiques pour la connexion de deux éléments conducteurs. En outre, les espèces supramoléculaires fibrillaires qui sont formées s'orientent d'elles-mêmes parallèlement aux lignes du champ électrique appliqué entre les surfaces (S) et (S'), c'est-à-dire selon un faisceau parallèle de « nanofils » s'étendant radialement par rapport aux surfaces conductrices (S) et (S'), ce qui constitue la conformation optimale pour assurer une connexion électrique maximale entre les deux surfaces. De plus, la connexion s'effectue de façon rapide, avec des temps de réponse au plus

de l'ordre de la seconde.

En plus de cette conformation particulièrement favorable, il s'avère en outre que, de façon inattendue, les espèces supramoléculaires fibrillaires formées lors de l'étape (E) sont de très bon conducteurs, avec une conductivité de l'ordre de celle des meilleurs conducteurs organiques connus aujourd'hui (typiquement de l'ordre de plusieurs dizaines de kilo Siemens par mètre), et avec en outre un comportement de conducteurs ohmiques, contrairement à la plupart des polymères conducteurs. En d'autres termes, ces espèces supramoléculaires se comportent schématiquement comme des nanofils métalliques, avec notamment une résistance qui diminue avec la température (notamment dans la plage entre 4 et 298 K). De façon particulièrement surprenante, cet effet est obtenu dans le cadre de la présente invention avec des espèces qui sont purement organiques, sans nécessiter la mise en oeuvre des cations métalliques additionnels qui sont classiquement employés à titre de dopants dans de nombreux polymères organiques conducteurs. Cette possibilité de s'affranchir de la mise en oeuvre de composés métalliques permet d'éviter les inconvénients associés en termes de toxicité et de répercussion sur l'environnement, ce qui constitue encore un aspect particulièrement intéressant du procédé de l'invention.

En outre, de façon encore plus inattendue, les inventeurs ont mis en lumière dans le cadre de la présente invention que les espèces supramoléculaires fibrillaires qui sont réalisées dans l'étape (E) conduisent à des résistances de contact particulièrement faibles au niveau du contact avec les surfaces (S) et (S'). En effet, la résistance de contact obtenue peut être aussi faible que de l'ordre de $10^{-2}$ Ω.cm dans la plupart des cas, contre des résistances de contact qui sont au minimum de l'ordre de 10 kΩ.cm avec la plupart des molécules préconisées dans l'état de la technique.

Il est par ailleurs à souligner que, contrairement à la plupart des composés organiques employés à titre de conducteurs électriques, les espèces supramoléculaires fibrillaires qui sont réalisées dans l'étape (E) conduisent à de bons résultats en termes de conductivité, notamment lorsque le matériau conducteur présent au niveau des surfaces (S) et (S') comprend de l'or. Des bons résultats sont en outre généralement obtenus quelle que soit la nature du matériau conducteur présent au niveau des surfaces (S) et (S'), ce qui rend le procédé particulièrement modulable.

Ainsi, il s'avère que l'étape (E) permet, de façon extrêmement simple et directe, de réaliser une connexion électrique efficace entre des objets conducteurs éloignés de quelques dizaines à quelques centaines de nanomètres, et ce quelle que soit leur nature physico-chimique exacte. Contre toute attente, cette connexion électrique particulièrement efficace est obtenue par une simple auto-association des composés de formule (I) lors de l'étape (E), sans avoir à mettre en oeuvre de techniques compliquées ou onéreuses. Les espèces supramoléculaires fibrillaires réalisées dans l'étape (E) constituent de ce fait une alternative extrêmement intéressante à des composés organiques tels que les polymères conjugués orientés qui sont, de très loin, beaucoup plus compliqués à synthétiser.

En plus de ces différents avantages, les inventeurs ont en outre mis en évidence dans le cadre de la présente invention que les espèces supramoléculaires fibrillaires déposées sur la surface (S) sont stables à température ambiante et qu'elles sont encore plus stables, y compris à plus haute température, une fois retiré le solvant employé dans l'étape (E) pour la formation de ces espèces. De ce fait, le plus souvent, dans le procédé de l'invention, l'étape (E) est suivie par une étape (E') d'élimination,du solvant employé dans l'étape (E), ce qui peut typiquement être réalisé par un simple rinçage. La mise en oeuvre de cette étape (E') permet de stabiliser les espèces supramoléculaires fibrillaires fixées sur les surfaces (S) et éventuellement (S'), ces espèces restant en général stables et solidarisées sur la surface (S), et sur la surface (S') le cas échéant, même lorsqu'elles sont portées à des températures de l'ordre de 100°C. Cette étape (E') permet également d'éliminer les éventuels composés non engagés dans la formation des espèces supramoléculaires liées à la surface (S).

Il est à noter qu'en présence de solvant, au contraire, les espèces supramoléculaires fibrillaires tendent à se désassembler à haute température, en particulier à une température de l'ordre de 100°C, pour conduire à la formation d'une solution comprenant les composés (I) sous forme solubilisée. Cette spécificité rend réversible la formation des espèces supramoléculaires fibrillaires de l'étape (E). Ainsi, au besoin, une connexion électrique telle qu'obtenue à l'issue de l'étape (E) peut être rompue très simplement en portant le milieu à une température de l'ordre de 100°C, si le solvant n'a pas été retiré. Cette possibilité permet par exemple de corriger d'éventuelles erreurs de connexion lors de la fabrication de circuits électriques ou électroniques. Si l'étape (E') a été mise en oeuvre, une telle réversibilité est encore envisageable. Il suffit alors, pour désassembler les espèces supramoléculaires fibrillaires, de remettre ces espèces en présence de solvant, puis de porter le milieu à une température de 100°C. Le caractère réversible du procédé constitue encore un de ses nombreux atouts, le rendant tout particulièrement adapté à une mise en oeuvre industrielle. Ce caractère réversible de la formation des espèces supramoléculaires fibrillaires à partir des composés de formule (I) permet de les envisager pour la réalisation de mémoires.

Différents avantages, caractéristiques, et modes de réalisation préférentiels de réalisation de l'invention vont maintenant être décrits plus en détails.

<u>Les **triarylamines de formule (I)**</u>

De préférence, les triarylamines de formule (I) employées dans l'étape (E) sont une population de molécules

identiques. Toutefois, il n'est pas exclu, selon certains modes, d'utiliser un mélange de plusieurs triarylamines distinctes.

Selon un mode de réalisation bien adapté à la mise en oeuvre de la présente invention, les triarylamines de formule (I) employées dans l'étape (E) sont des composés où chacun des groupes -$A^1$- et -$A^2$- est un groupe -O-.

Par ailleurs, il se révèle généralement intéressant que, dans les triarylamines de formule (I) employées dans l'étape (E), chacun des groupes $R^1$ et $R^2$, représente, indépendamment :

- un groupe benzyle ; ou
- un groupe alkyle, avantageusement linéaire, comprenant typiquement de 6 à 18 atomes de carbone, de préférence de 7 à 10 atomes de carbone.

Ainsi, selon un mode intéressant, les triarylamines de formule (I) employées dans l'étape (E) peuvent par exemple répondre à la formule (la) ci-dessous :

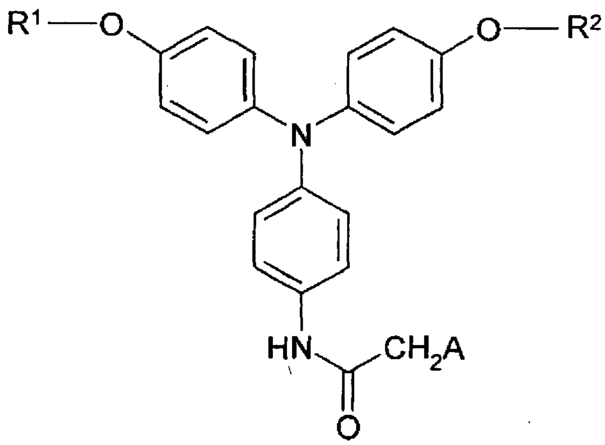

(la)

dans laquelle :

- chacun des groupes $R^1$ et $R^2$, identiques ou différents (et de préférence identiques), a une des significations précitées et désigne de préférence un groupe benzyle ou bien un groupe alkyle, avantageusement linéaire, comprenant de 6 à 18, par exemple 7 à 10, et notamment 8 atomes de carbone ;
- A est un groupe hydrogène -H ; un groupement halogéno, par exemple un groupe -Cl ; ou bien un groupe alkyle comprenant typiquement de 1 à 8 atomes de carbone (par exemple 5, 6, ou 7 atomes de carbone).

Des triarylamines adaptées à la mise en oeuvre de l'invention incluent notamment, de façon non limitative, les composés répondant à la formule (la) ci-dessus où $R^1$, $R^2$, et A ont l'une des significations suivantes :

- $R^1 = R^2 = C_8H_{17}$ (linéaire) et A= Cl ; ou
- $R^1 = R^2 = C_8H_{17}$ (linéaire) et A= H ; ou
- $R^1 = R^2 = C_8H_{17}$ (linéaire) et A= $C_6H_{13}$; ou
- $R^1 = R^2$ = benzyle et A= H ; ou
- $R^1 = R^2$ = benzyle et A= Cl.

Un procédé de préparation de ces composés a notamment été décrit dans Angew. Chem. Int. Ed., vol. 49, pp. 6974-6978 (2010).

Quelle que soit la nature exacte des triarylamines mises en oeuvre dans l'étape (E), celles-ci sont mises en oeuvre au sein d'un solvant. Ce solvant peut être choisi parmi tous les solvants capables de solubiliser les composés de formule (I) employés dans l'étape (E). Des solvants bien adaptés dans ce cadre sont les solvants chlorés, tels que le chloroforme, le dichlorométhane ou bien encore le 1,1,2,2-tétrachloroéthane.

L'étape (E') d'élimination de ce solvant peut typiquement être réalisée en utilisant un de ces mêmes solvants

chlorés comme solvant de rinçage.

Les triarylamines sont en général mises en oeuvre dans l'étape (E) sous la forme de solutions ayant des concentrations de l'ordre de 1 à 100 mmol/L, de préférence entre 5 et 20 mmol/L. De telles solutions sont des compositions liquides à température ambiante et nettement moins visqueuses que les compositions usuelles de polymères organiques conducteurs connues de l'état de la technique, cette faible viscosité permettant d'améliorer le contrôle et la maniabilité par rapport aux procédés employant ce type de polymères, ce qui constitue encore un avantage non négligeable du procédé de l'invention.

**La différence de potentiel appliquée dans l'étape (E)**

Dans le procédé de l'invention, une différence de potentiel est appliquée entre la surface (S) et la surface (S'), de sorte à induire un champ électrique dans l'espace situé entre ces deux surfaces. En général cette différence de potentiel est négative, de façon à induire le greffage des espèces supramoléculaires fibrillaires au moins sur la surface (S).

La valeur absolue de cette différence de potentiel doit être suffisante pour induire l'effet recherché, mais elle doit cependant ne pas être trop élevée pour ne pas conduire à des conductivités trop basses. La valeur de la différence de potentiel doit par ailleurs être adaptée à la distance entre les surfaces (S) et (S'). A titre indicatif, pour une distance entre les surfaces (S) et (S') de l'ordre de 80 à 100 nm, par exemple, la valeur absolue de la différence de potentiel appliquée lors de l'étape (E) entre les surfaces (S) et (S') est de préférence de l'ordre de 10 à 700 mV, plus préférentiellement de 50 à 500 mV, par exemple entre 100 et 400 mV, notamment entre 200 et 400 mV.

Pour le même écart entre les surfaces (S) et (S'), dans le cas particulier de l'emploi des composés de formule (Ia) précitée, et tout particulièrement dans le cas des composés de formule (Ia) où $R^1 = R^2 = C_8H_{17}$ et A= Cl, la valeur absolue de la différence de potentiel appliquée lors de l'étape (E) entre les surfaces (S) et (S') est de préférence comprise entre 250 et 350 mV, typiquement de l'ordre de 300 mV.

L'établissement de la différence de potentiel peut se faire selon tout moyen connu en soi, le plus simple étant de relier les surfaces (S) et (S') aux bornes d'un générateur électrique délivrant la tension recherchée.

Selon une variante la mise en oeuvre de la différence de potentiel débute avant la mise en contact des surfaces (S) et (S') des matériaux conducteurs solides avec la solution comprenant les triarylamines. Selon une autre variante la mise en oeuvre de la différence de potentiel débute après cette mise en contact. Selon une autre variante la mise en oeuvre de la différence de potentiel débute au moment de cette mise en contact.

Selon une variante préférée, il est appliqué une différence de potentiel initial d'au moins 0,1V et de préférence d'au moins 0,3V entre les électrodes, avant irradiation lumineuse.

**La radiation électromagnétique appliquée dans l'étape (E)**

Lors de l'étape (E), les composés de formule (I) sont soumis à une irradiation par un rayonnement électromagnétique propre à les activer, à savoir à les convertir au moins en partie en des radicaux triarylammonium.

Le rayonnement employé à cet effet contient au moins des longueurs d'onde d'énergie permettant l'obtention de la conversion recherchée. Pour un composé de formule (I) donné, cette longueur d'onde est très aisée à déterminer car elle correspond en général au maximum d'absorption $\lambda_{max}$ du composé sur un spectre d'absorption UV-visible.

Par exemple, pour le composé de formule (Ia) précité où $R^1 = R^2 = C_8H_{17}$ et A= Cl, la longueur d'onde efficace se situe aux alentours de 350-365 nm.

En général, la longueur d'onde utile pour activer un composé de formule (I) donné fait partie du spectre de la lumière solaire. Dès lors, l'irradiation de l'étape (E) peut avantageusement être effectuée, selon un mode particulier, en soumettant le milieu de l'étape (E) à un rayonnement solaire. Ce mode de réalisation particulièrement simple et peu onéreux rend le procédé très aisé à réaliser.

Alternativement, l'étape (E) peut être conduite en utilisant une partie uniquement du spectre solaire. Dans ce cas, les longueurs d'onde employées comprennent avantageusement au moins les longueurs comprises entre $\lambda_{max}$ -25 nm et $\lambda_{max}$+25 nm, plus préférentiellement au moins les longueurs comprises entre $\lambda_{max}$ -50 nm et $\lambda_{max}$+50 nm.

Concernant l'irradiation, il est à noter que sa puissance a un effet sur la formation des espèces supramoléculaires fibrillaires à base des composés (I). En règle générale, ces espèces se forment d'autant plus rapidement que la puissance est élevée. Néanmoins, des puissances d'irradiation trop élevées sont à éviter car elles sont susceptibles de conduire à des phénomènes parasites tels que l'induction d'une réaction de polymérisation radicalaire. A titre indicatif, en particulier pour les composés de formule (Ia) précités, une puissance de l'ordre de 100 W est adaptée (par exemple entre 50 et 200 W, soit rapporté à la distance des puissances de l'ordre de 10 $W.cm^{-2}$ mais pouvant être plus basse, et au moins aussi basse que 0.01 $W.cm^{-2}$ suivant le temps d'irradiation appliqué »), alors que des puissances de 1000 W nuisent à la qualité du résultat obtenu.

L'irradiation peut être remplacée par une étape d'oxydation chimique, par exemple en utilisant un oxydant tel que DDQ (dichlorodicyanoquinone) en quantité catalytiques (typiquement 1%). Il est également possible de former les

radicaux initiateurs de l'auto-assemblage fibrillaire par électrochimie en oxydant le dérivé triarylamine.

Quel que soit le mode de réalisation mis en oeuvre, la conduite des étapes (E) et (E') de la présente invention est très simple et peu onéreuse. En plus des avantages précités, il est en outre à souligner à ce sujet que ces étapes peuvent avantageusement être conduites à température ambiante.

Du fait de sa facilité de mise en oeuvre et de sa grande modularité, le procédé de l'invention se prête à une grande variété d'applications.

En particulier, les étapes (E) et (E') peuvent être employées pour connecter entre eux deux conducteurs électriques, par exemple deux constituants d'un circuit électronique. Dans ce cadre, le procédé de l'invention peut être employé à toute échelle, incluant des circuits miniaturisés, voire nanométriques.

Une application particulière du procédé de l'invention concerne la réparation de circuits électroniques localement interrompus. Dans ce cadre, les étapes (E) et (E') peuvent être employées pour effectuer localement l'équivalent d'une « soudure » sur une partie endommagée du circuit électronique, en reconnectant le circuit interrompu à l'aide des espèces supramoléculaires fibrillaires. Dans ce cas, les surfaces (S) et (S') peuvent par exemple être les deux lèvres de part et d'autre d'une cassure ou d'une zone endommagée ayant conduit à une perte de conduction.

De façon plus générale, le procédé de l'invention peut être employé pour tout dépôt d'espèces supramoléculaires fibrillaires du type précité sur une surface conductrice, sous une forme organisée, à savoir liées à la surface et s'entendant radialement par rapport à cette surface.

Dans ce cadre, la réponse relativement rapide du système permet d'envisager une « écriture » sur une surface conductrice, en déplaçant parallèlement à cette surface une surface (S') de plus faible dimension, cette surface (S') jouant alors le rôle d'une pointe (tête d'impression) définissant en se déplaçant un motif sur la surface conductrice. Ce mode de réalisation peut par exemple être employé pour l'écriture optique de pistes conductrices à base des espèces supramoléculaires fibrillaires sur un support conducteur. De telles pistes conductrices permettent une conduction de type métallique en ayant en outre l'avantage d'être mécaniquement flexibles contrairement aux pistes métalliques.

Selon la revendication indépendante 14, la présente invention a pour objet les matériaux conducteurs modifiés en surface par des espèces supramoléculaires fibrillaires à base des triarylamines de formule (I), du type de ceux qu'on obtient à l'issue de l'étape (E) et de l'éventuelle étape (E') définie ci-dessus.

Dans ce cadre, la présente invention a pour objet les matériaux qui sont concrètement obtenus selon les étapes (E) et éventuellement (E'), mais également tous les matériaux présentant les mêmes caractéristiques mais obtenus selon une autre méthode conduisant au même résultat.

En particulier, l'invention englobe les matériaux conducteurs qui portent en surface des espèces supramoléculaires fibrillaires à base des triarylamines de formule (I) qui sont obtenus en employant non pas une irradiation, mais un agent oxydant, pour induire la conversion des triarylamines de formule (I) en des radicaux triarylammonium.

L'invention concerne également les matériaux conducteurs qui portent en surface des espèces supramoléculaires fibrillaires à base des triarylamines de formule (I) qui sont obtenus en traitant par voie électrochimique un matériau conducteur en présence de triarylamines de formule (I).

Les matériaux de l'invention peuvent être mis en oeuvre en parallèle à une technique dite descendante ou approche « top-down » (lit. de haut en bas) telle que l'impression à jet d'encre, de préférence à haute résolution, ou une méthode lithographique, éventuellement utilisant des motifs induits par la lumière.

L'invention permet aussi des applications pour les soudures de circuits électroniques ou bio-électroniques, et concerne donc que de telles méthodes.

La présente invention et ses avantages seront encore davantage illustrés au vu de l'exemple ci-après.

Sur les figures :

La figure 1 représente une vue schématique de la géométrie d'un nano-sillon associé à une mesure de conductance typique et aux images par microscopie à force atomique (AFM). (A) représente en particulier une solution de composés de l'invention déposée en gouttes, dans le noir, sur des électrodes Au/Ni nano-désignées (« nano-patterned »). La différence de potentiel entre les deux électrodes appliquée est comprise entre 0,3 et 0,8V. La conductance mesurée pour l'interconnexion sans les structures de l'invention et de l'ordre du picoSiemens. L'échantillon est ensuite soumis à la lumière, ce qui produit des radicaux induisant les structures supramoléculaires de l'invention par polymérisation radicalaire vivante résultant en l'auto-assemblage aligné selon le champ électrique et en la forte connexion des deux électrodes. (B) : topographie d'un sillon libre (à gauche) vu par AFM avant irradiation et, après irradiation, comblé par les structures supramoléculaires de l'invention (à droite). (C) Image AFM avant irradiation montrant un nano-sillon (surface 1500x1500nm$^2$). (D) Image AFM après irradiation (surface 1500x1500nm$^2$) : on voit le nano-sillon comblé par des nano-fils ou nano-filaments. (E) Zoom sur le nano-sillon comblé par les nano-fils (surface 250x250nm$^2$).

La figure 2 représente la nature ohmique et les caractéristiques de conductivité des structures supramoléculaires en fonction de la température : (A) courbe courant versus voltage, mesurée à basse température (1,5K). (B) mesure

de R(T) normalisé de trois dispositifs fonctionnalisés par des structures supramoléculaires de l'invention, entre la température ambiante et 1,5K. Les résistances initiales pour chaque échantillon à 300K sont les suivantes : 22, 45 et 360 Ω. Chaque échantillon est corrélé en utilisant l'équation

$$\frac{1}{R}(T) = \frac{1}{R_0} \exp\left(\frac{\hbar\omega_0}{k_B T}\right)$$

où kb est la constante de Boltzman, et

Où $\hbar\omega_0$ est l'énergie de photons.

La figure 3 représente un design d'électrodes : (A) Nano-sillon d'électrodes observé au microscope électronique à balayage (SEM). (B) Zoom illustrant quatre pseudo-points de connexion, limitant la résistance en série des interconnexions en dessous de 2 Ω. (C) Zoom sur le nano-sillon illustrant une distance typique inférieure à 100 nm.

La figure 4 représente les mesures courant versus voltage I(V): (A) I(V) d'un nano-sillon vide (largeur 100μm, longueur 0,08μm), (B) I(V) d'un nano-sillon de référence immergé dans une solution des composés de l'invention, avant irradiation lumineuse. Le courant résiduel est attribué aux impuretés ioniques dans la solution. (C) I(V) d'un nano-sillon après auto-assemblage des composés de l'invention sous irradiation lumineuse. (D) I(V) d'un nano-sillon montrant l'effet du voltage appliqué durant l'irradiation lumineuse initiale (losanges : 0,01 V, cercles : 0,1 V, carrés : 0,3 V).

La figure 5 représente la conductance différentielle mesurée à 200 K sous vide en utilisant la technique d'un pont AC. (A) diminution de la conductance avec la différence de potentiel indiquant un chauffage possible des échantillons en solution. (B) Courbe intégrée illustrant des valeurs de courant de quelques dizaines de mA aux plus fortes différences de potentiels.

**Exemple 1**

On a réalisé une connexion de deux électrodes selon le procédé de l'invention, en employant un dispositif du type de celui décrit dans Nanotechnology, 21, 335303 (2010), qui présente deux électrodes en regard.

Pour ce faire, on a employé un composé répondant à la formule (Ia) précitée, où $R^1 = R^2 = C_8H_{17}$ (linéaire) et A= Cl, dissous à raison de 10 mmol/L dans du chloroforme.

La solution du composé a été placée dans la gorge entre les deux électrodes, puis on a irradié le dispositif avec de la lumière blanche avec une puissance de 100 W, tout en imposant une différence de potentiel de 300 mV entre les électrodes.

On a alors constaté la formation très rapide d'une connexion électrique entre les deux électrodes, qui se traduit par une mesure de la conductivité entre les deux électrodes : avant le traitement, on mesure un courant de l'ordre de quelques picoAmpères entre les deux électrodes, contre un courant de 0,5 A (soit $10^8$ fois plus important) après le traitement.

Des clichés de microscopie révèlent la présence des espèces supramoléculaires fibrillaires qui assurent la connexion électrique entre les électrodes, organisées parallèlement, en s'étendant perpendiculairement à la surface des électrodes.

**Exemple 2**

On a réalisé par une technique de lithographie optique sur un substrat de silicium des électrodes d'Au et de Ni, les surfaces des électrodes étant séparées par une distance d'environ 80±20 nm, sur une largeur de 100μm. Le courant résiduel est inférieur à 1pA entre les deux surfaces. Ce circuit a été immergé dans une solution de molécules de formule (Ia) et en particulier de molécules de formule (Ia), où $R^1 = R^2 = C_8H_{17}$ (linéaire) et A= Cl, dans du 1,1,2,2-tétrachloroéthane ($C_2H_2Cl_4$) (Fig. 1A), en l'absence de lumière. Il a été observé une augmentation du courant entre les électrodes de quelques centaines de pA sous un voltage différentiel de quelques centaines de mV (voir Fig. 4). Suite à une irradiation en utilisant une lumière blanche on observe une augmentation par six du courant atteignant ainsi des valeurs dans la plage des mA. La conductance correspondante est de quelques dizaines de mS. Ces dispositifs à 2 terminaux avec des canaux et des interfaces de contacts en séries présentent une nature résistive ohmique liée à des valeurs de conductivité élevées comme montré par la mesure de l'intensité en fonction du voltage I(V) (selon les figures 2A et 4). La conductivité du canal est estimée comme allant au-delà de $10^4$ S.m$^{-1}$. De manière alternative il est estimé que la résistance d'interface par unité de longueur est égale ou supérieure à $10^{-4}$ Ω.m. Cette valeur est de l'ordre de six fois inférieure à celle des meilleurs contacts de cristaux organiques simples et inférieure à ce qui est obtenu avec des flocons de graphènes.

Après lavage intense des échantillons avec le solvant, l'imagerie par Microscopie à Force Atomique (AFM)

révèle une longueur de « nanofils » des structures supramoléculaires organiques conductrices exactement en adéquation avec la distance entre les surfaces d'électrodes (Fig. 1B-E), avec des orientations suivant le champ électrique appliqué à l'ensemble et avec un diamètre homogène de 12±2 nm. Il a été découvert qu'il était important d'appliquer un seuil de voltage initial (d'au moins 0,1V et de préférence d'au moins 0,3V?) entre les électrodes, avant irradiation lumineuse, pour obtenir efficacement et de manière stable des structures supramoléculaires fibrillaires.

Il a également été observé que le procédé de préparation de ces structures peut être réversible lorsque l'on chauffe l'échantillon, par exemple à 60°C pendant une nuit, puisque les structures supramoléculaires formées se dissolvent. Après l'assemblage et désassemblages répétés (six fois) les interconnexions métalliques n'ont pas été significativement affectées par les cycles de chauffage.

Après évaporation du solvant les structures obtenues deviennent stables et procurent des résultats reproductibles après une nuit de chauffage à 100°C. Les performances des échantillons ne sont pas notablement sensibles à l'humidité ni à l'oxygène ce qui est très positif pour des dispositifs électroniques organiques. Il n'a pas été nécessaire de travailler en conditions d'atmosphère inerte durant la préparation des structures supramoléculaires. Après un mois de stockage, les échantillons ont montré des propriétés conductrices comparables.

Des études en fonction de la température ont confirmé que les échantillons présentent une conductivité élevée car ils révèlent systématiquement et de manière fiable une résistivité diminuant avec la température, jusqu'à 1,5K (Fig. 2B). Il a été également remarqué le profil ohmique des structures jusqu'à des courants élevés à basse température (Fig. 2A). Pour les échantillons montrant la plus faible résistance il a été observé des courants jusqu'à 25 mA lorsqu'ils sont soumis à une différence de potentiel de 1V, sous vide (Fig. 4B). La densité de courant est estimée de l'ordre de $10^7$ $A.cm^{-2}$, ce qui est remarquablement élevé pour des composés organiques et correspond à des courants de densité d'électro-migration dans des circuits métalliques.

**Exemple 3**

Il a également été réalisé des échantillons avec des analogues des composés de l'exemple 1. Il a été remarqué dans une configuration de test en aveugle que la distance inter-électrodes n'était comblée par des structures supramoléculaires que lorsqu'elles sont capables de s'auto-assembler. Ceci confirme que les propriétés conductrices résultent des structures supramoléculaires de l'invention. Les composés suivants ont été testés :

Tableau 1 :

| Molécule | Comportement en solution déterminé par RMN $^1M$ | Etat du sillon |
|---|---|---|
| 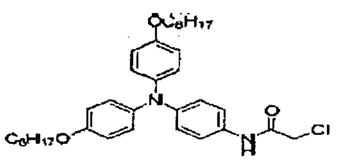 1 | auto-assemblé | fermé |
| 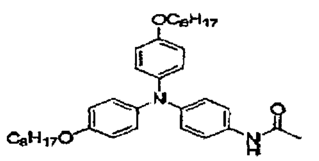 2 | auto-assemblé | fermé |
| 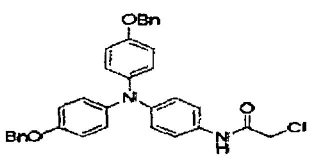 3 | auto-assemblé | fermé |
| 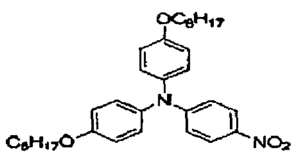 4 | non-assemblé | ouvert |

(suite)

| Molécule | Comportement en solution déterminé par RMN 1M | Etat du sillon |
|---|---|---|
| 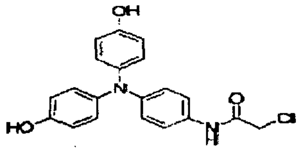 5 | non-assemblé | ouvert |
| 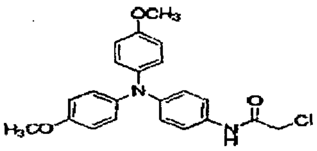 6 | non-assemblé | Fermé mais non stable au lavage |

Il a été déterminé par RMN 1H que les composés 1-3 s'auto-assemblent dans des solutions de CDCl3 sous stimulation lumineuse, ce qui n'est pas le cas des composés 4-6. Cette propriété liée à la structure montre que seuls les composés de l'invention présentent la capacité de s'auto-assembler.

L'expérimentation a été effectuée par tests en aveugles. La personne ayant préparé les solutions n'a pas effectué les mesures de conductivité. Les échantillons étaient codés. Chaque échantillon a été mesuré sous les mêmes conditions : la différence de potentiel de 1 Volt a été appliqué sur la solution de triarylamines 1-6 (1 mg.mL-1), simultanément à une irradiation de 100 W à distance constante pendant une période de 10 secondes (≈10 W.cm-2); puis la dépendance I/V a été mesurée pour chaque distance. Les résultats sont résumés dans le tableau 1. Les corrélations montrent clairement que la conductivité est dépendante de l'auto-assemblage.

Images des nano-sillons

La morphologie et la différence entre les électrodes avant et après auto-assemblage ont été observées. Pour cela il a été utilisé un microscope électronique à balayage (SEM) et un microscope à force atomique (AFM) pour obtenir des informations qualitatives et quantitatives sur les nano-sillons.

Les images prises par AFM (Fig .1C, D et E)) donnent une indication précise de la structure fibrillaire des nano-sillons comblés.

**Exemple 4**

Des électrodes ont été fabriquées à l'aide d'un masque lithographique et d'un ombrage dirigé par l'angle de dépôt (« edge mediated shadow mask litography ») selon la technologie décrite dans J-F Dayen et al ; Nanotrench for nano and microparticle electrical interconnects ; Nanotechnology 21 335303 (2010) - Une tri-couche Ti(5nm)/Ni(35nm)/Au(20nm) a été déposée en premier par évaporation de vapeur d'électrons « electron beam evaporation », suivi d'un procédé de « lift-off » standard. La seconde étape comprend la déposition sous un angle de 60°, en créant une tri-couche Ti(5nm)/Ni(25nm)/Au(10nm) suivi par un « lift-off ». La première électrode présente une composition reliée à la superposition des deux étapes, et la seconde électrode, plus fine, présente une composition correspondant seulement à la seconde couche de la tri-couche déposée (ceci explique la différence de hauteur observée par AFM). Les « nano-sillons » ont été fabriqués avec une distance fixe inter-électrodes de 80 nm et une longueur de 100μ m (Fig. 3). Après vérification de l'absence de courant résiduel, une solution du composé de formule (Ia), où $R^1 = R^2 = C_8H_{17}$ (linéaire) et A= Cl (à 1mg/mL dans C2H2Cl4), a été déposée par dépôt de gouttes (« drop casting ») sur les électrodes. Une différence de potentiel avec un courant continu de plus de 0,3V et jusqu'à 0,8 V a été immédiatement appliquée entre les électrodes, l'évolution du courant en fonction du temps a été enregistrée en utilisant un appareil de mesure de fortes résistances (électromètres) du type Keithley 6517B Electrometer/High Resistance Meter. L'échantillon a été irradié durant quelques secondes sous illumination par microscope condenseur (« microscope condenser illumination ») (ouverture numérique de 0,55) avec une source lumineuse halogène de 100 W. Un filtre infrarouge été utilisé pour limiter le chauffage de l'échantillon à quelques degrés, ce qui résulte en une irradiation de densité de puissance à large bande de 10 $W.cm^{-2}$. Le temps d'irradiation typique de 10 s correspond au nombre total de photons utilisés en environ 30 minutes pour réaliser un auto-assemblage en solution utilisant une densité de puissance d'environ 0,07 $W.cm^{-2}$, ce qui est plus que nécessaire pour générer l'auto-assemblage. Il a également été découvert qu'un métal de transition dans l'électrode était nécessaire pour assurer une interconnexion de l'auto-assemblage plus satisfaisante.

On ne peut pas obtenir d'auto-assemblage stable et fiable entre des électrodes d'Au et de Pt seulement (avec une couche d'adhésion de Ti). L'auto-assemblage présente un taux de réussite supérieur à 90 % entre deux électrodes de Ni et de Fe. Il a été découvert que d'utiliser un dépôt d'or (Au) sur les électrodes procure une stabilité des échantillons à long terme meilleure, et permet de surmonter le problème de l'oxydation de surface des métaux de transition.

D'autre part il a été mis en évidence un effet d'amorçage de la croissance de l'auto-assemblage avec un substrat du type métal de transition.

Après la formation des structures supramoléculaires, les échantillons ont été rincés avec du chloroforme, suivi d'un lavage intensif avec de l'acétone et de l'éthanol, puis finalement séchés avec un courant d'azote.

Des mesures électriques à basse température ont été réalisées avec un cryostat à pompe à vide ($P < 10^{-6}$ mbar) ou dans un système de flux d'hélium (He) abaissant la température à 1,5 K. Les mesures des propriétés électriques ont été réalisées avec un analyseur Agilent E5270B semiconductor parameter analyzer (propriétés DC), et avec un amplificateur SRS 830 lock-in amplifier (propriétés AC).

Il a également été réalisé des mesures de conductance différentielle à 200K sous vide. Des courants d'intensité de quelques dizaines de mA ont été observés de manière reproductible avec une différence de potentiel de 1V appliquée sur différents échantillons (Fig 5).

## Revendications

1. Dispositif conducteur comprenant deux matériaux métalliques conducteurs dont les surfaces, respectivement (S) et (S'), sont interconnectées électriquement par un matériau organique comprenant des espèces supramoléculaires organiques fibrillaires conductrices comprenant une association des triarylamines de formule (I) ci dessous :

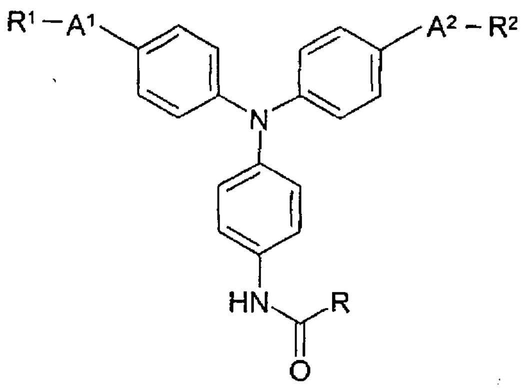

(I)

où :

- chacun des groupes $-A^1-$ et $-A^2-$, identiques ou différents, désigne une liaison covalente simple ou bien un groupe -O- , -S-, -NH- -NH(C=O)-, ou - $NR^3$- ;
- chacun des groupes $R^1$, $R^2$ et $R^3$, identiques ou différents, représente :

  - un groupe aromatique, de préférence un groupe benzyle ; ou
  - une chaîne hydrocarbonée comprenant de 4 à 30 atomes de carbone; ou
  - une chaîne polyéthylène glycol ;

et

- R est un groupe de terminaison, qui est de préférence une chaîne hydrocarbonée, comprenant avantageusement de 1 à 10 atomes de carbone, éventuellement halogénée et éventuellement interrompue par un ou plusieurs hétéroatomes choisis parmi N, O ou S.

2. Dispositif, selon la revendication 1, caractérisé en que ledit dispositif conducteur présente une interface métallique/organique et en ce que lesdites surfaces (S) et (S') sont séparées d'une distance de 10 à 500 nm, et de préférence de 50 à 200 nm, et dans lequel ledit matériau organique comprenant lesdites espèces supramoléculaires organiques fibrillaires comble la distance séparant les deux surfaces (S) et (S').

3. Dispositif, selon l'une quelconque des revendications 1 à 2, **caractérisé en ce que** les espèces supramoléculaires

organiques fibrillaires sont orientées en faisceau parallèle de « nanofils » s'étendant radialement par rapport aux surfaces conductrices (S) et (S').

4. Dispositif, selon l'une quelconque des revendications 1 à 3, **caractérisé en ce que** les espèces supramoléculaires organiques fibrillaires présentes une longueur correspondant à la distance séparant les surfaces (S) et (S') des deux matériaux métalliques.

5. Procédé de modification d'une surface (S) d'un matériau conducteur solide, qui comprend une étape (E), dans laquelle on applique une différence de potentiel, généralement négative, entre ladite surface (S) et une surface (S') d'un autre matériau solide conducteur disposé en regard de la dite surface (S), simultanément à la mise en contact de ladite surface (S) avec un milieu liquide comprenant, en solution, des triarylamines répondant à la formule (I) ci dessous :

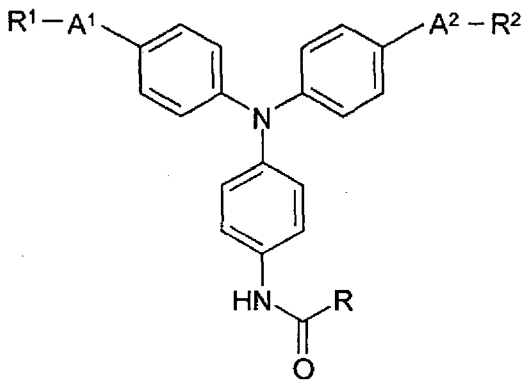

(I)

où :

- chacun des groupes $-A^1-$ et $-A^2-$, identiques ou différents, désigne une liaison covalente simple ou bien un groupe -O- , -S-, -NH-, -NH(C=O)-, ou - $NR^3$-;
- chacun des groupes $R^1$, $R^2$ et $R^3$, identiques ou différents, représente :

  - un groupe aromatique, de préférence un groupe benzyle ; ou
  - une chaîne hydrocarbonée comprenant de 4 à 30 atomes de carbone; ou
  - une chaîne polyéthylène glycol ;

et
- R est un groupe de terminaison, qui est de préférence une chaîne hydrocarbonée, comprenant avantageusement de 1 à 10 atomes de carbone, éventuellement halogénée et éventuellement interrompue par un ou plusieurs hétéroatomes choisis parmi N, O ou S,

tout en soumettant les triarylamines (I) à une radiation électromagnétique ou encore à une oxydation chimique ou électrochimique propre à les convertir au moins en partie en des radicaux triarylammonium.

6. Procédé selon la revendication 5, permettant la connexion électrique des surface conductrices (S) et (S'), où les surfaces en regard (S) et (S') sont distantes de 1 micron ou moins.

7. Procédé selon la revendication 5 ou 6, où l'étape (E) est suivie par une étape (E') d'élimination du solvant employé dans l'étape (E).

8. Procédé selon l'une des revendications 5 à 7, où chacun des groupes $-A^1-$et $-A^2-$ est un groupe -O-.

9. Procédé selon l'une des revendications 5 à 8, où chacun des groupes $R^1$ et $R^2$, représente, indépendamment :

   - un groupe benzyle ; ou
   - un groupe alkyle comprenant de 6 à 18 atomes de carbone.

**10.** Procédé selon l'une des revendications 5 à 9, où les triarylamines employées dans l'étape (E) répondent à la formule (Ia) ci-dessous :

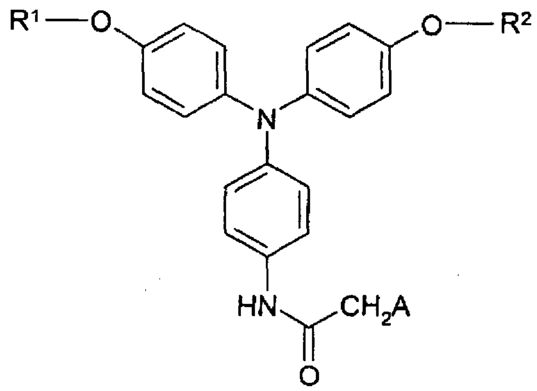

**(Ia)**

dans laquelle :

- chacun des groupes $R^1$ et $R^2$, identiques ou différents, est tel que défini dans la revendication 5, et désigne de préférence un groupe benzyle ou bien un groupe alkyle comprenant de 6 à 18 atomes de carbone ;
- A est un groupe hydrogène -H ; un groupement halogéno ; ou bien un groupe alkyle comprenant typiquement de 1 à 8 atomes de carbone.

**11.** Procédé selon la revendication 10, où les triarylamines employées dans l'étape (E) répondent à la formule (Ia) ci-dessous, où $R^1$, $R^2$, et A ont l'une des significations suivantes :

- $R^1 = R^2 = C_8H_{17}$ (linéaire) et A= Cl ; ou
- $R^1 = R^2 = C_8H_{17}$ (linéaire) et A= H ; ou
- $R^1 = R^2 = C_8H_{17}$ (linéaire) et A= $C_6H_{13}$ ; ou
- $R^1 = R^2$ = benzyle et A= H ; ou
- $R^1 = R^2$ = benzyle et A= Cl.

**12.** Procédé selon l'une des revendications 5 à 11, où le solvant employé dans l'étape (E) est un solvant chloré, tel que le chloroforme, le dichlorométhane ou le 1,1,2,2-tétrachloroéthane.

**13.** Procédé selon l'une des revendications 5 à 12, où l'irradiation de l'étape (E) est effectuée en soumettant le milieu de l'étape (E) à un rayonnement solaire.

**14.** Matériau conducteur modifié en surface par des espèces supramoléculaires fibrillaires à base des triarylamines de formule (I) telle que définie dans la revendication 1, susceptible d'être obtenu selon le procédé de l'une des revendications 5 à 13.

**15.** Utilisation d'espèces supramoléculaires organiques fibrillaires comprenant des triarylamines répondant à la formule (I) ci dessous :

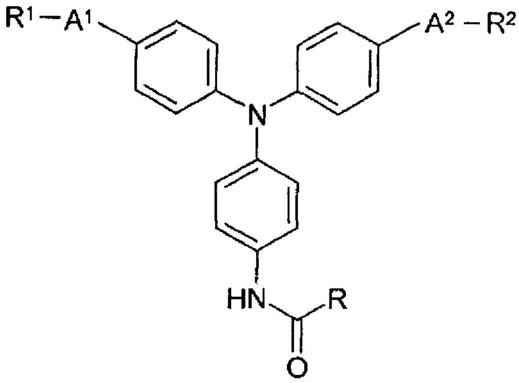

(I)

où:

- chacun des groupes $-A^1-$ et $-A^2-$, identiques ou différents, désigne une liaison covalente simple ou bien un groupe -O-, -S-, -NH-, -NH(C=O), ou - $NR^3$-;
- chacun des groupes $R^1$, $R^2$ et $R^3$, identiques ou différents, représente :

  - un groupe aromatique, de préférence un groupe benzyle ; ou
  - une chaîne hydrocarbonée comprenant de 4 à 30 atomes de carbone; ou
  - une chaîne polyéthylène glycol ;

et
- R est un groupe de terminaison, qui est de préférence une chaîne hydrocarbonée, comprenant avantageusement de 1 à 10 atomes de carbone, éventuellement halogénée et éventuellement interrompue par un ou plusieurs hétéroatomes choisis parmi N, O ou S,

ou susceptibles d'être obtenues selon le procédé de l'une des revendications 5 à 13, pour relier entre elles les surfaces (S) et (S') de deux électrodes conductrices.

**Patentansprüche**

1. Leitvorrichtung, umfassend zwei leitende metallische Materialien, deren Oberflächen (S) beziehungsweise (S') durch ein organisches Material elektrisch miteinander verbunden sind, welches supramolekulare, organische, leitfähige, fibrilläre Spezies umfasst, die einen Verbund von Triarylaminen der unten gezeigten Formel (I) umfassen:

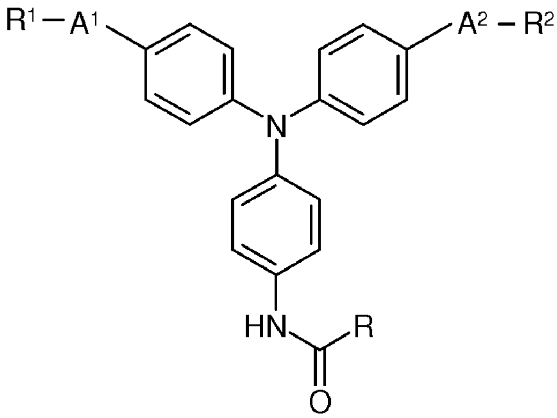

(I)

wobei

- jede der Gruppen $-A^1-$ und $-A^2-$, die gleich oder verschieden sind, eine kovalente Einfachbindung oder eine -O-, -S-, -NH-, -NH(C=O)- oder $-NR^3$-Gruppe bezeichnet;

- jede der Gruppen $R^1$, $R^2$ und $R^3$, die gleich oder verschieden sind,

  - eine aromatische Gruppe, vorzugsweise eine Benzylgruppe; oder
  - eine Kohlenwasserstoffkette, welche 4 bis 30 Kohlenstoffatome umfasst; oder
  - eine Polyethylenglykolkette

darstellt;
und
- R eine endständige Gruppe ist, die vorzugsweise eine Kohlenwasserstoffkette ist, welche vorteilhafterweise 1 bis 10 Kohlenstoffatome umfasst, gegebenenfalls halogeniert ist und gegebenenfalls durch ein oder mehrere Heteroatome, ausgewählt aus N, O oder S, unterbrochen ist.

2. Vorrichtung gemäß Anspruch 1, **dadurch gekennzeichnet, dass** die Leitvorrichtung eine metallisch/organische Schnittstelle aufweist und dass die Oberflächen (S) und (S') durch einen Abstand von 10 bis 500 nm, vorzugsweise von 50 bis 200 nm voneinander getrennt sind und wobei das organische Material, welches die supramolekularen, organischen, fibrillären Spezies umfasst, den Abstand, der die beiden Oberflächen (S) und (S') voneinander trennt, ausfüllt.

3. Vorrichtung gemäß irgendeinem der Ansprüche 1 bis 2, **dadurch gekennzeichnet, dass** die supramolekularen, organischen, fibrillären Spezies als paralleler Strahl von "Nanodrähten" orientiert sind, welche sich radial in Bezug auf die leitenden Oberflächen (S) und (S') erstrecken.

4. Vorrichtung gemäß irgendeinem der Ansprüche 1 bis 2, **dadurch gekennzeichnet, dass** die supramolekularen, organischen, fibrillären Spezies eine Länge aufweisen, die dem Abstand, der die Oberflächen (S) und (S') der beiden metallischen Materialien voneinander trennt, entspricht.

5. Verfahren zum Modifizieren einer Oberfläche (S) eines festen leitenden Materials, welches einen Schritt (E) umfasst, in dem eine Potentialdifferenz, in der Regel negativ, zwischen der Oberfläche (S) und einer Oberfläche (S') eines anderen festen leitenden Materials, das gegenüber der Oberfläche (S) angeordnet ist, angelegt wird, gleichzeitig mit dem Inkontaktbringen der Oberfläche (S) mit einem flüssigen Medium, welches Triarylamine entsprechend der unten gezeigten Formel (I) in Lösung umfasst:

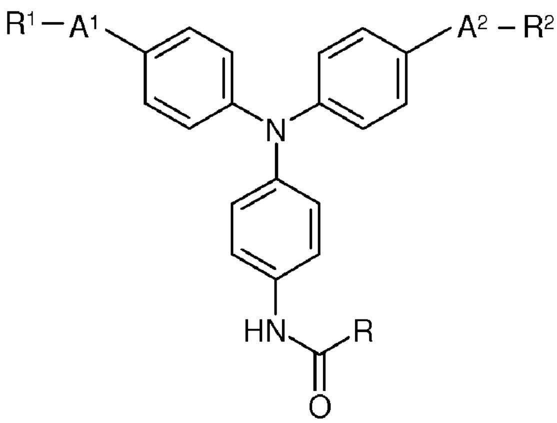

(I)

wobei

- jede der Gruppen -$A^1$- und -$A^2$-, die gleich oder verschieden sind, eine kovalente Einfachbindung oder eine -O-, -S-, -NH-, -NH(C=O)- oder -$NR^3$-Gruppe bezeichnet;
- jede der Gruppen $R^1$, $R^2$ und $R^3$, die gleich oder verschieden sind,

  - eine aromatische Gruppe, vorzugsweise eine Benzylgruppe; oder
  - eine Kohlenwasserstoffkette, welche 4 bis 30 Kohlenstoffatome umfasst; oder
  - eine Polyethylenglykolkette

darstellt;
und
- R eine endständige Gruppe ist, die vorzugsweise eine Kohlenwasserstoffkette ist, welche vorteilhafterweise 1 bis 10 Kohlenstoffatome umfasst, gegebenenfalls halogeniert ist und gegebenenfalls durch ein oder mehrere Heteroatome, ausgewählt aus N, O oder S, unterbrochen ist,

während die Triarylamine (I) einer elektromagnetischen Bestrahlung oder ferner einer chemischen oder elektrochemischen Oxidation unterzogen werden, welche geeignet ist, diese zumindest teilweise in Triarylammonium-Radikale umzuwandeln.

**6.** Verfahren gemäß Anspruch 5, welches die elektrische Verbindung der leitenden Oberflächen (S) und (S') erlaubt, wobei die einander zugewandten Oberflächen (S) und (S') 1 Mikrometer oder weniger voneinander beabstandet sind.

**7.** Verfahren gemäß Anspruch 5 oder 6, wobei dem Schritt (E) ein Schritt (E') der Beseitigung des in Schritt (E) eingesetzten Lösungsmittels folgt.

**8.** Verfahren gemäß einem der Ansprüche 5 bis 7, wobei jede der Gruppen $-A^1-$ und $-A^2-$ eine -O-Gruppe ist.

**9.** Verfahren gemäß einem der Ansprüche 5 bis 8, wobei jede der Gruppen $R^1$ und $R^2$ unabhängig voneinander

- eine Benzylgruppe; oder
- eine Alkylgruppe, welche 6 bis 18 Kohlenstoffatome umfasst, darstellt.

**10.** Verfahren gemäß einem der Ansprüche 5 bis 9, wobei die in Schritt (E) eingesetzten Triarylamine der unten gezeigten Formel (Ia) entsprechen:

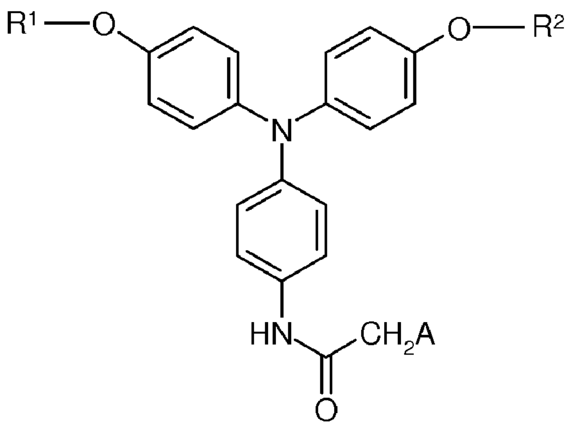

(Ia)

wobei

- jede der Gruppen $R^1$ und $R^2$, die gleich oder verschieden sind, wie in Anspruch 5 definiert ist und vorzugsweise eine Benzylgruppe oder eine Kohlenwasserstoffgruppe, welche 6 bis 18 Kohlenstoffatome umfasst, bezeichnet;
- A eine Wasserstoffgruppe -H; eine Halogen-Gruppierung oder eine Alkylgruppe, welche typischerweise 1 bis 8 Kohlenstoffatome umfasst, ist.

**11.** Verfahren gemäß Anspruch 10, wobei die in Schritt (E) eingesetzten Triarylamine der unten gezeigten Formel (Ia) entsprechen, wobei $R^1$, $R^2$ und A eine der folgenden Bedeutungen haben:

- $R^1 = R^2 = C_8H_{17}$ (linear) und A = Cl; oder
- $R^1 = R^2 = C_8H_{17}$ (linear) und A = H; oder
- $R^1 = R^2 = C_8H_{17}$ (linear) und $A = C_6H_{13}$; oder
- $R^1 = R^2$ = Benzyl und A = H; oder
- $R^1 = R^2$ = Benzyl und A = Cl.

**12.** Verfahren gemäß einem der Ansprüche 5 bis 11, wobei das in Schritt (E) eingesetzte Lösungsmittel ein chlorhaltiges Lösungsmittel ist, wie Chloroform, Dichlormethan oder 1,1,2,2-Tetrachlorethan.

**13.** Verfahren gemäß einem der Ansprüche 5 bis 12, wobei die Bestrahlung in Schritt (E) durchgeführt wird, indem das Medium in Schritt (E) einer Sonnenstrahlung unterzogen wird.

**14.** Leitendendes Material, welches auf der Oberfläche durch supramolekulare, fibrilläre Spezies auf Basis von Triarylaminen der Formel (I), wie in Anspruch 1 definiert, modifiziert ist, erhältlich durch ein Verfahren gemäß einem der Ansprüche 5 bis 13.

**15.** Verwendung von supramolekularen, organischen, fibrillären Spezies, welche Triarylamine umfassen, die der der unten gezeigten Formel (I) entsprechen:

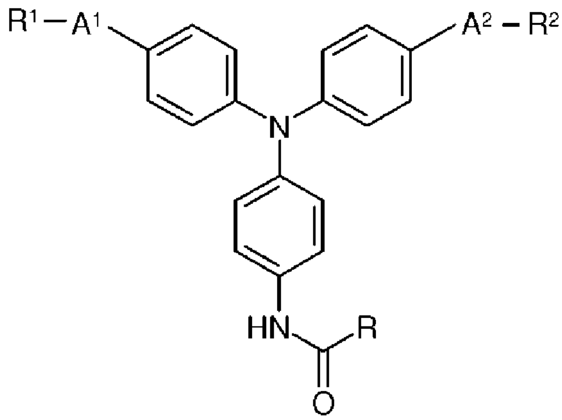

(I)

wobei

- jede der Gruppen $-A^1-$ und $-A^2-$, die gleich oder verschieden sind, eine kovalente Einfachbindung oder eine -O-, -S-, -NH-, -NH(C=O)- oder $-NR^3$-Gruppe bezeichnet;
- jede der Gruppen $R^1$, $R^2$ und $R^3$, die gleich oder verschieden sind,

    - eine aromatische Gruppe, vorzugsweise eine Benzylgruppe; oder
    - eine Kohlenwasserstoffkette, welche 4 bis 30 Kohlenstoffatome umfasst; oder
    - eine Polyethylenglykolkette

  darstellt;
  und
- R eine endständige Gruppe ist, die vorzugsweise eine Kohlenwasserstoffkette ist, welche vorteilhafterweise 1 bis 10 Kohlenstoffatome umfasst, gegebenenfalls halogeniert ist und gegebenenfalls durch ein oder mehrere Heteroatome, ausgewählt aus N, O oder S, unterbrochen ist,
  oder erhältlich durch ein Verfahren gemäß einem der Ansprüche 5 bis 13

zum miteinander Verbinden der Oberflächen (S) und (S') von zwei leitenden Elektroden.

## Claims

**1.** A conducting device comprising two conducting metal materials, the surfaces of which, (S) and (S'), respectively, are electrically interconnected with an organic material comprising conducting fibrillar organic supramolecular species comprising an association of triarylamines of formula (I) below:

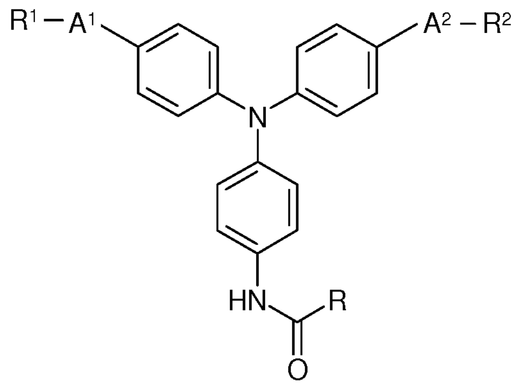

(I)

wherein:

- each of the groups -$A^1$- and -$A^2$-, either identical or different, designates a simple covalent bond or else a group -O- , -S-, -NH- -NH(C=O)-, or -NR $^3$-;
- each of the groups $R^1$, $R^2$ and $R^3$, either identical or different, represents:

  - an aromatic group; preferably or a benzyl group ; or
  - a hydrocarbon chain comprising from 4 to 30 carbon atoms; or
  - a polyethylene glycol chain;

and
- R is a terminating group, which is preferably a hydrocarbon chain, comprising advantageously from 1 to 10 carbon atoms, optionally halogenated and optionally interrupted with one or more heteroatoms selected from N, O or S.

**2.** The device according to claim 1, wherein said conducting device has a metal/organic interface and in that said surfaces (S) and (S') are separated by a distance from 10 to 500 nm and preferably from 50 to 200 nm, and in which said organic material comprising said fibrillar organic supramolecular species fills the gap separating both surfaces (S) and (S').

**3.** The device, according to any one of claims 1 to 2, wherein the fibrillar organic supramolecular species are oriented in a parallel bundle of « nano-wires » extending radially relatively to the conducting surfaces (S) and (S').

**4.** The device according to any one of claims 1 to 3, wherein the fibrillar organic supramolecular species have a length corresponding to the distance separating the surfaces (S) and (S') of both metal materials.

**5.** A Process for modifying a surface (S) of a solid conducting material, which comprises a step (E) in which a potential difference, generally negative, is applied between said surface (S) and a surface (S') of another conducting solid material positioned facing said surface (S), simultaneously upon putting said surface (S) in contact with a liquid medium comprising in solution triarylamines fitting the formula (I) below:

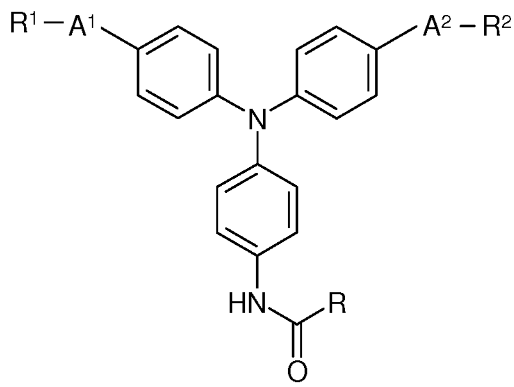

(I)

wherein:

- each of the groups $-A^1-$ et $-A^2-$, either identical or different designates a simple covalent bond or else a group -O-, -S-, -NH-, -NH(C=O)-, or $-NR^3-$;
- each of the groups $R^1$, $R^2$ and $R^3$, either identical or different, represents:

  - an aromatic group preferably a benzyl group ; or
  - a hydrocarbon chain comprising from 4 to 30 carbon atoms; or
  - a polyethylene glycol chain;

and
- R is a terminating group which is preferably a hydrocarbon chain, comprising advantageously from 1 to 10 carbon atoms, optionally halogenated and optionally interrupted with one or more heteroatoms selected from N, O or S.

while subjecting the triarylamines (I) to electromagnetic radiation or to chemical or electrochemical oxidation for at least partly converting them into triarylammonium radicals.

**6.** The process according to claim 5, allowing electric connection of the conducting surfaces (S) and (S') where the surfaces (S) and (S') facing each other are distant from each other by 1 micron or less.

**7.** The process according to claim 5 or 6, wherein step (E) is followed by a step (E') for removing the solvent used in step (E).

**8.** The process according to any one of claims 5 to 7, wherein each of the groups$-A^1-$ et $-A^2-$ is a group -O-.

**9.** The process according to any one of claims 5 to 8, wherein each of the groups $R^1$ and $R^2$, represents, independently:

- a benzyl group; or
- an alkyl group comprising from 6 to 18 carbon atoms.

**10.** The process according to any one of claims 5 to 9, wherein the triarylamines used in step (E) fit the formula (Ia) below:

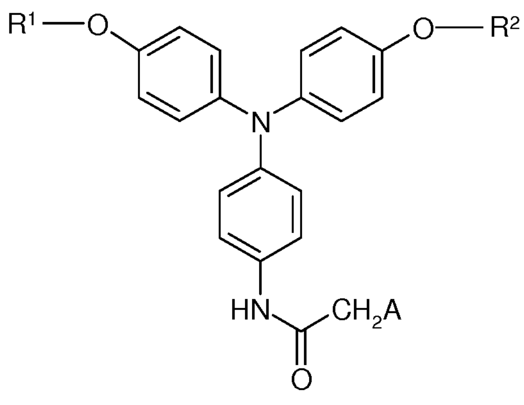

(Ia)

wherein:

- each of the groups $R^1$ and $R^2$, either identical or different, is as defined in claim 5, and represents preferably a benzyl group or an alkyl group comprising from 6 to 18 carbon atoms ;
- A is a hydrogen group -H; a halogen group; or an alkyl group comprising typically from 6 to 18 carbon atoms.

**11.** The process according to claim 10, wherein the triarylamines used in step (E) fit the formula (Ia) below, wherein $R^1$, $R^2$, and A have one of the following meanings:

- $R^1 = R^2 = C_8H_{17}$ (linear) and A= Cl; or

- $R^1 = R^2 = C_8H_{17}$ (linear) and A= H; or
- $R^1 = R^2 = C_8H_{17}$ (linear) and A= $C_6H_{13}$; or
- $R^1 = R^2$= benzyl and A= H; or
- $R^1 = R^2$ = benzyl and A= Cl.

**12.** The process according to any one of claims 5 to 11, wherein the solvent used in step (E) is a chlorinated solvent, such as chloroform, dichloromethane or 1,1,2,2-tetrachloroethane.

**13.** The process according to any one of claims 5 to 12, wherein the irradiation of step (E) is carried out by subjecting the medium of step (E) to solar radiation.

**14.** A conducting material modified at the surface with fibrillar supramolecular species based on triarylamines of formula (I) as defined in claim 1, which may be obtained according to the process according to anyone of claims 5 to 13.

**15.** Use of fibrillar organic supramolecular species comprising triarylamines fitting the formula (I) below:

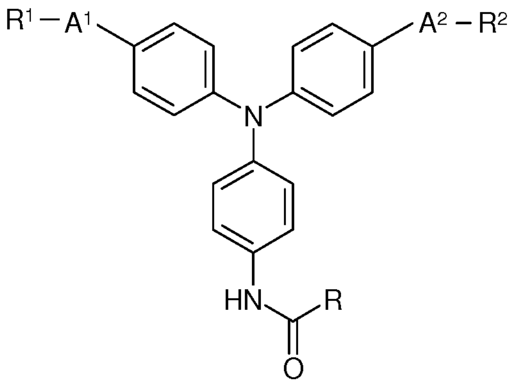

(I)

wherein:

- each of the groups $-A^1-$ and $-A^2-$, either identical or different, designates a simple covalent bond or else a group -O- , -S-, -NH-, -NH(C=O), or $-NR^3-$;
- each of the groups $R^1$, $R^2$ and $R^3$, either identical or different, represents:
  - an aromatic group preferably a benzyl group ; or
  - a hydrocarbon chain comprising from 4 to 30 carbon atoms; or
  - a polyethylene glycol chain;

and
- R is a terminating group which is preferably a hydrocarbon chain, comprising advantageously from 1 to 10 carbon atoms, optionally halogenated and optionally interrupted with one or more heteroatoms selected from N, O or S ;

or which may be obtained according to the process of any one of claims 5 to 13 for connecting together the surfaces (S) and (S') of two conducting electrodes.

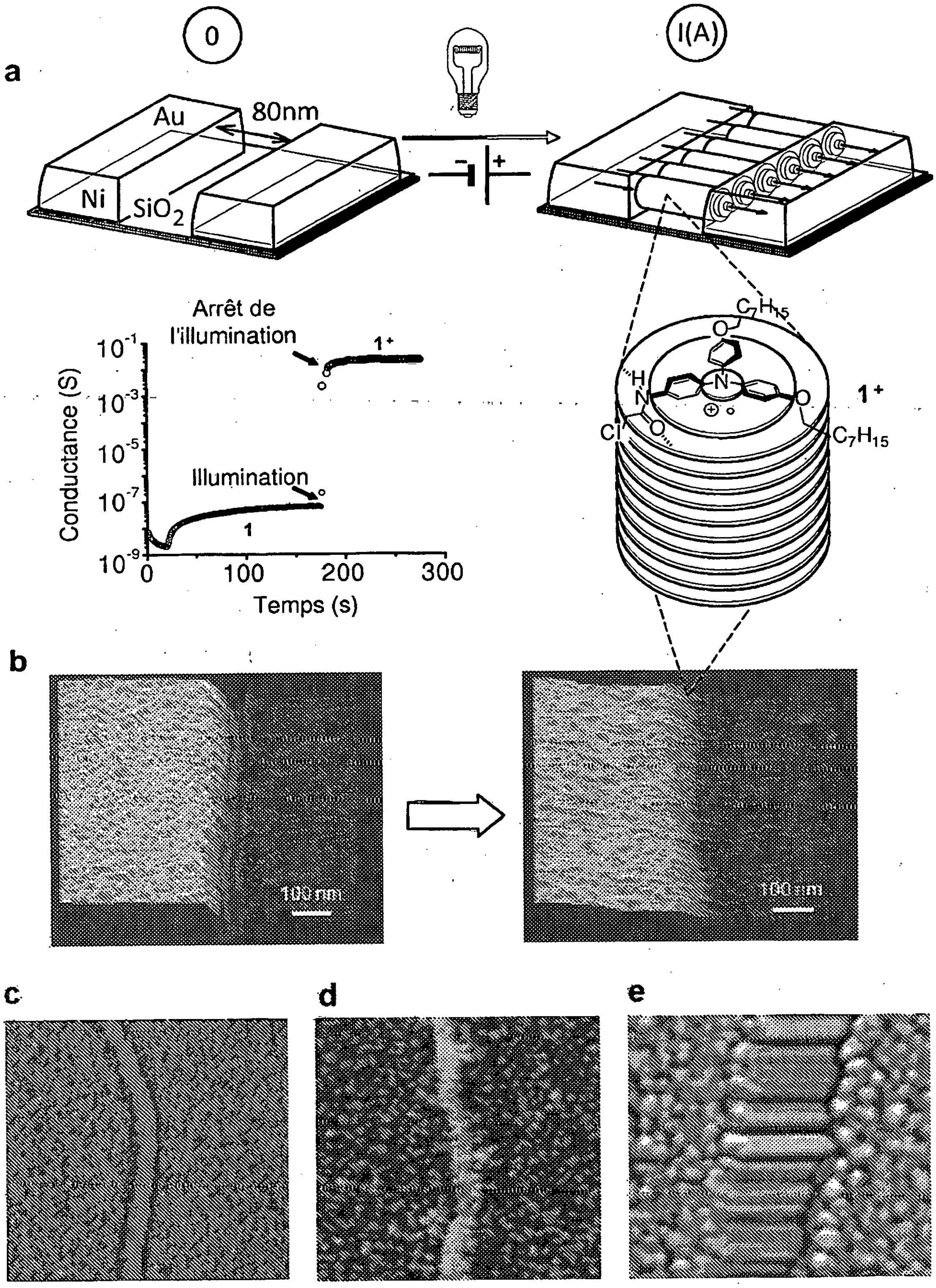
a
0
I(A)
Au
80nm
Ni
SiO2
Arrêt de
l'illumination
Illumination
Conductance (S)
Temps (s)
1+
1
b
100 nm
c
d
e

FIG.1

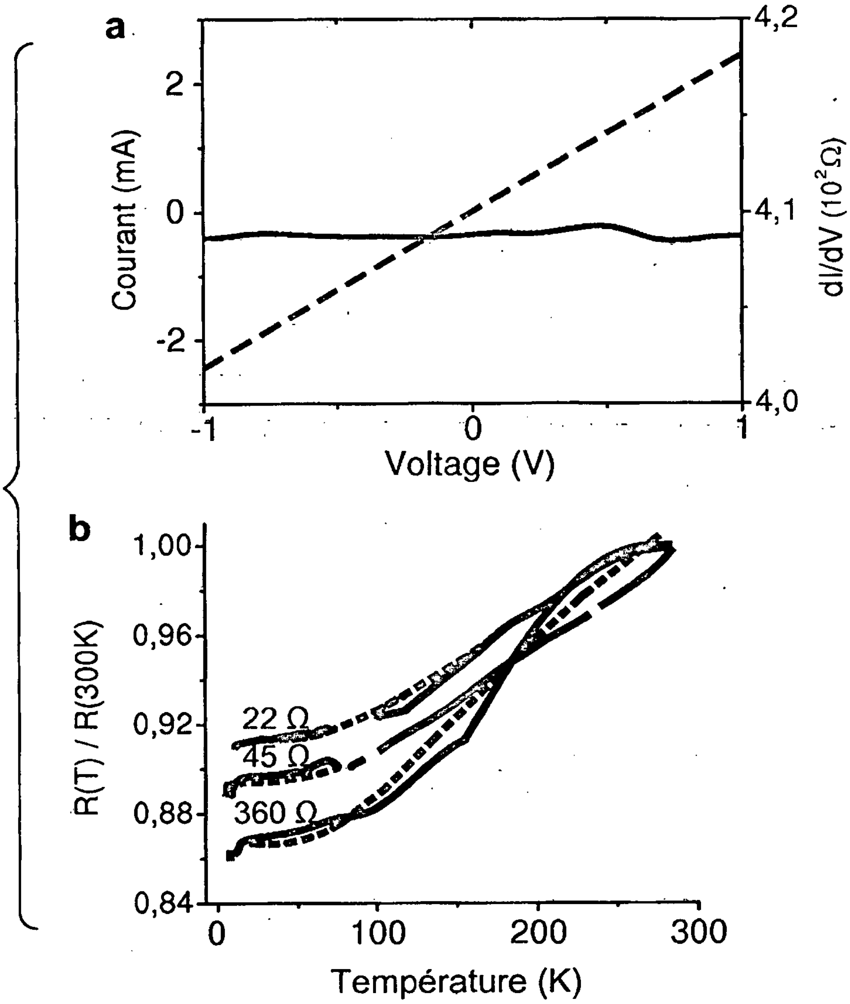
a
Courant (mA)
2
0
-2
4,2
4,1
4,0
dI/dV ($10^2\Omega$)
-1
0
1
Voltage (V)
b
R(T) / R(300K)
1,00
0,96
0,92
0,88
0,84
22 Ω
45 Ω
360 Ω
0
100
200
300
Température (K)

FIG.2

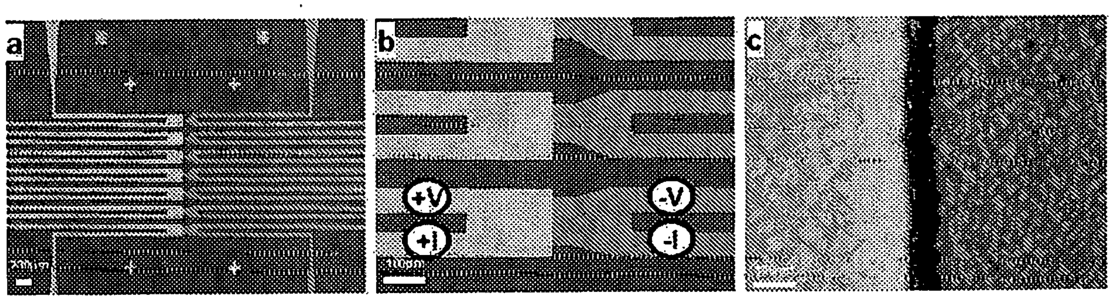
a
b
c
+V
-V
+I
-I

FIG.3

FIG. 4

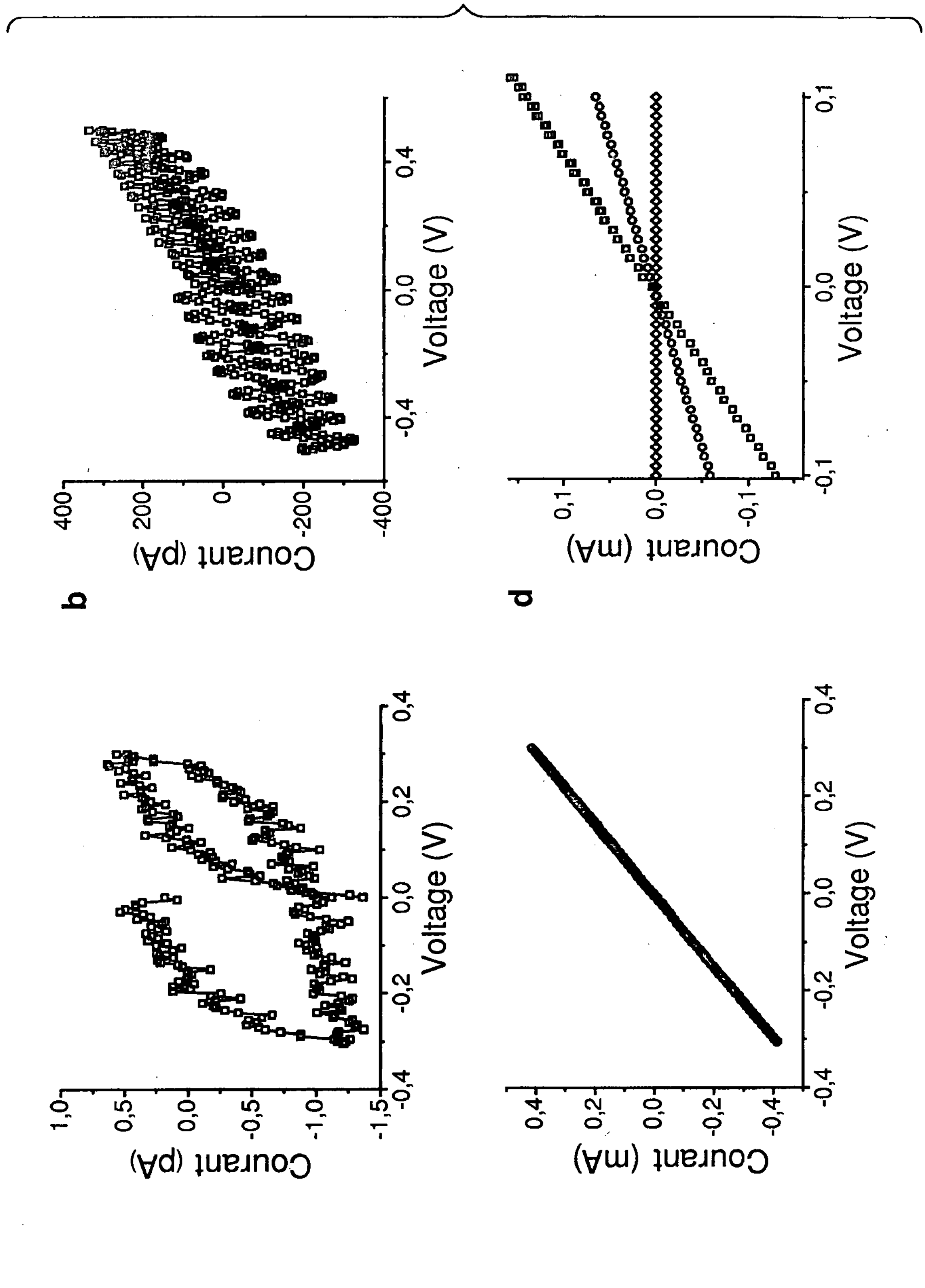

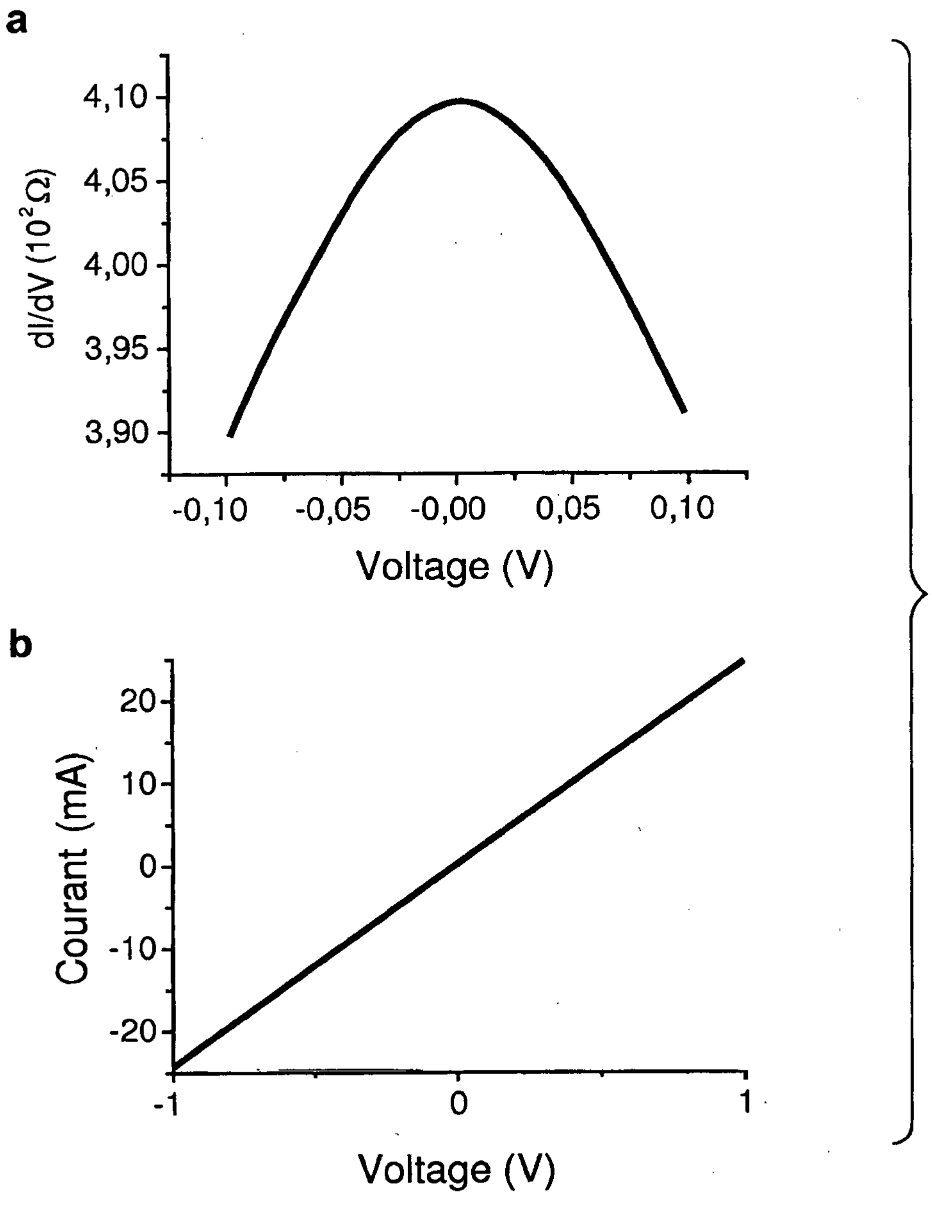
a
4,10
4,05
4,00
3,95
3,90
dI/dV ($10^2\Omega$)
-0,10
-0,05
-0,00
0,05
0,10
Voltage (V)
b
20
10
0
-10
-20
Courant (mA)
-1
0
1
Voltage (V)

FIG.5

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

### Littérature non-brevet citée dans la description


- **DAYEN J.-F. et al.** Nanotrench for nano and microparticle electrical interconnects. *NANOTECHNOLOGY,* 27 Juillet 2010, vol. 21, 335303-1, 335303-7
- *Angew. Chem. Int. Ed.,* 2010, vol. 49, 6974-6978
- *Nanotechnology,* 2010, vol. 21, 335303
- **J-F DAYEN et al.** Nanotrench for nano and microparticle electrical interconnects. *Nanotechnology,* 2010, vol. 21, 335303